# FASCICULE DE BREVET EUROPEEN

(11) **EP 3 748 850 B1**
(45) Date de publication et mention de la délivrance du brevet: **22.01.2025**
(21) Numéro de dépôt: 20178195.2
(22) Date de dépôt: 04.06.2020
(51) Int. Cl.: H03K 17/082

(54) **DÉTECTION D'UN DÉFAUT ÉLECTRIQUE DANS UN DISPOSITIF ÉLECTRONIQUE DE PUISSANCE**
ERKENNUNG EINES ELEKTRISCHEN DEFEKTS IN EINER ELEKTRONISCHEN LEISTUNGSVORRICHTUNG
DETECTION OF AN ELECTRICAL DEFECT IN AN ELECTRONIC POWER DEVICE

(30) Priorité: 05.06.2019 FR 1905955
(43) Date de publication de la demande: 09.12.2020
(73) Titulaire: ALSTOM Holdings, 93400 Saint-Ouen-sur-Seine (FR)
(72) Inventeur: BARLINI, Davide, 65320 Borderes sur L'Echez (FR); KUCH, Thomas, 65000 Tarbes (FR); ROUMAS, Alexandre, 64420 Soumoulou (FR)
(74) Mandataire: Lavoix

(56) Documents cités:
- US-A1- 2017 104 338

## Description

La présente invention se rapporte à la détection d'un défaut électrique dans un dispositif électronique de puissance.

Dans le domaine de l'électronique de puissance, des composants électroniques comportant un ou plusieurs interrupteurs de puissance, tels que des modules IGBT (Insulated-Gate Bipolar Transistor) ou MOSFET (Metal-Oxide Field Effect Transistor), sont parfois associés à un dispositif de surveillance permettant de détecter l'apparition d'un défaut électrique, notamment un court-circuit, à l'intérieur du composant.

Généralement, le dispositif de surveillance comporte un ou plusieurs capteurs de courant et/ou de tension associés au transistor de puissance, par exemple pour surveiller la tension V_{CE} entre le collecteur et l'émetteur du transistor et/ou pour mesurer la variation de courant électrique en sortie du transistor lors de la commutation du transistor. La présence d'un défaut électrique est détectée en fonction des valeurs de courant et/ou de tension mesurées.

US 2017/104338 A1 divulgue un circuit électrique comportant un commutateur à semi-conducteur avec une première borne et une seconde borne pour conduire un courant de puissance, et un capteur pour détecter une vitesse de changement de courant du courant de puissance circulant à travers le commutateur à semi-conducteur. Le capteur comprend une feuille isolante configurée pour être connectée à la première ou à la seconde borne du commutateur à semi-conducteur, et une inductance disposée sur la feuille isolante sur un côté de celle-ci qui est disposé à l'opposé d'un côté faisant face au commutateur à semi-conducteur pendant une opération de mesure du capteur afin de détecter un champ magnétique généré par le courant de puissance pour fournir une tension de mesure basée sur le champ magnétique détecté. L'inductance est espacée du commutateur à semi-conducteur au moins par la feuille isolante, de sorte que la mesure sans contact est activée.

Toutefois, de telles techniques de détection ne permettent pas toujours de réagir suffisamment vite pour détecter le défaut et interrompre dès que possible l'alimentation électrique du composant électronique avant que ce dernier soit endommagé. Cela est généralement causé par un temps de traitement des données trop long.

Il existe donc un besoin pour détecter plus rapidement un défaut électrique dans un dispositif tel qu'un dispositif électronique de puissance.

A cet effet, un aspect de l'invention concerne un dispositif, notamment un dispositif électronique de puissance, selon la revendication 1.

Grâce à l'invention, la mesure du champ magnétique permet de détecter une variation du courant électrique et ainsi d'identifier rapidement un comportement révélateur d'un défaut électrique, notamment un court-circuit, de préférence lorsque la commutation des interrupteurs de puissance est amorcée.

Un tel défaut électrique peut ainsi être identifié plus rapidement dans le dispositif qu'avec les méthodes classiquement utilisées, ce qui permet d'interrompre l'alimentation électrique avant que le dispositif ne soit endommagé.

Selon des aspects avantageux mais non obligatoires, un tel dispositif peut incorporer une ou plusieurs des caractéristiques suivantes, prises isolément ou suivant toute combinaison techniquement admissible :
- La bobine est adjacente aux première et deuxième bornes de connexion et est configurée pour générer une tension qui est fonction du champ magnétique créé dans ledit plan géométrique par un ou des courants électriques qui circulent par les première et deuxième bornes de connexion.
- Le circuit de traitement est configuré pour détecter un défaut électrique lors de la commutation des interrupteurs de puissance lorsque la tension générée par la bobine est supérieure à un seuil de tension, ledit seuil de tension étant de préférence supérieur à 0 Volts.
- Le dispositif comporte une deuxième bobine montée sur la plaque de support et connectée au circuit de traitement, la deuxième bobine étant adjacente aux première et deuxième bornes de connexion et placée à l'opposé de l'autre bobine par rapport aux première et deuxième bornes de connexion.
- Le circuit de traitement est configuré pour détecter un défaut électrique lors de la commutation des interrupteurs de puissance lorsque le champ magnétique mesuré par l'appareil de détection indique que l'intensité du courant entrant par la première borne de connexion augmente dans des mêmes proportions que l'intensité du courant sortant par la deuxième borne de connexion, les sens de circulation de ces deux courants étant opposés.
- Le circuit de traitement est configuré pour détecter un défaut électrique lors de la commutation des interrupteurs de puissance lorsque le champ magnétique mesuré par l'appareil de détection indique que l'intensité du courant entrant par la première borne de connexion augmente alors qu'aucun courant ne circule par la deuxième borne de connexion.
- Le circuit de traitement est configuré pour considérer qu'aucun défaut électrique n'est présent lors de la commutation des interrupteurs de puissance lorsque le champ magnétique mesuré par l'appareil de détection indique que la variation de l'intensité du courant entrant par la première borne de connexion est opposée à la variation de l'intensité du courant sortant par la deuxième borne de connexion, les sens de circulation de ces deux courants étant les mêmes.

Selon un autre aspect, l'invention concerne un convertisseur de puissance comportant une pluralité de dispositifs de commutation électrique chacun tel que décrit précédemment, les interrupteurs de puissance desdits dispositifs étant raccordés de façon à former un circuit de conversion de puissance.

L'invention sera mieux comprise et d'autres avantages de celle-ci apparaîtront plus clairement à la lumière de la description qui va suivre d'un mode de réalisation d'un dispositif, notamment d'un dispositif de électronique puissance, donnée uniquement à titre d'exemple et faite en référence aux dessins annexés, dans lesquels :
[Fig 1] la figure 1 est un schéma électrique simplifié d'un dispositif selon des modes de réalisation de l'invention ;
[Fig 2] la figure 2 est une représentation schématique, selon une vue isométrique, du dispositif de la figure 1 ;
[Fig 3] la figure 3 représente un premier exemple de fonctionnement du dispositif de la figure 1 en présence d'un défaut électrique, notamment d'un court-circuit interne au dispositif ;
[Fig 4] la figure 4 représente un deuxième exemple de fonctionnement du dispositif de la figure 1 en présence d'un défaut électrique, notamment un court-circuit externe au dispositif ;
[Fig 5] la figure 5 représente un exemple de fonctionnement du dispositif de la figure 1 en l'absence de défaut électrique.

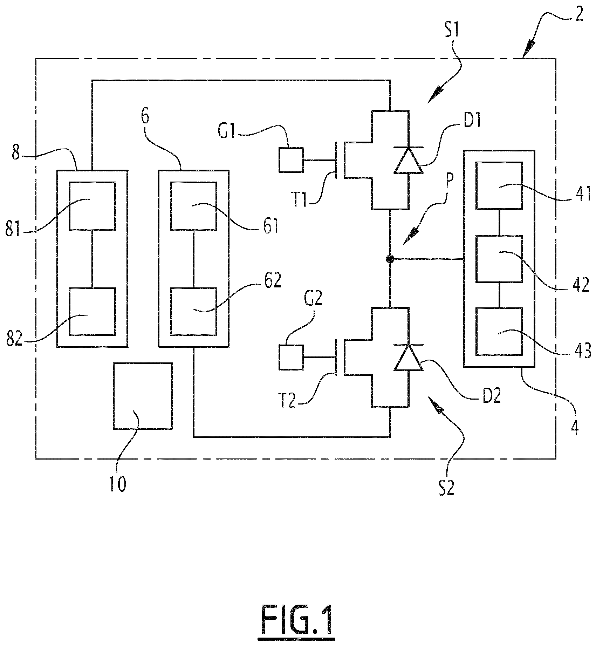

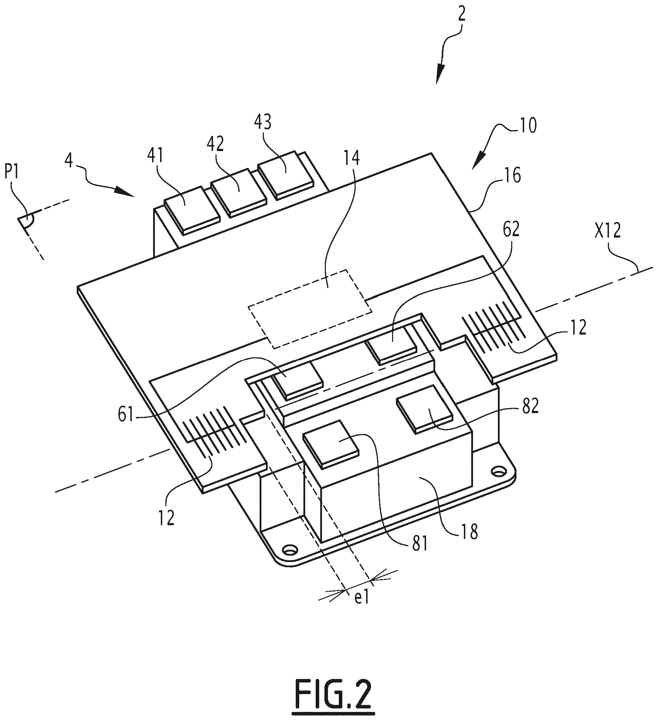

Les figures 1 et 2 représentent un dispositif 2, notamment un dispositif électronique de puissance.

Le dispositif 2 est préférentiellement destiné à être utilisé dans un circuit électrique ou un système électrique, tel qu'un convertisseur de puissance.

Le dispositif 2 comporte un premier interrupteur de puissance S1 et un deuxième interrupteur de puissance S2 connectés en série entre une première borne de connexion et une deuxième borne de connexion du dispositif 2, telles qu'une borne de phase et une borne de neutre.

Par exemple, le premier interrupteur de puissance S1 et le deuxième interrupteur de puissance S2 comportent chacun un transistor de puissance, respectivement notés T1 et T2.

Selon des exemples, les transistors de puissance T1 et T2 sont des transistors bipolaires à grille isolée (IGBT).

Avantageusement, les transistors de puissance T1 et T2 peuvent être des transistors MOSFET (Metal-Oxide Semiconductor Field-Effect Transistor), ou en variante des transistors JFET (Junction Gate Field-Effect Transistor), ou des transistors bipolaires, ou tout autre transistor de puissance approprié.

Dans l'exemple illustré, chaque interrupteur S1, S2 comporte une diode D1, D2 connectée en parallèle du transistor de puissance T1, T2 correspondant.

Par exemple, chaque interrupteur S1, S2 comporte une électrode de grille, respectivement notée G1 ou G2, connectée à la grille du transistor de puissance T1, T2 correspondant.

Dans l'exemple illustré, une borne de sortie 4, également appelée borne intermédiaire 4, est connectée à un point milieu P entre la source du premier transistor T1 et le drain du deuxième transistor T2.

La première borne de connexion du dispositif 2 porte ici la référence 8. La deuxième borne de connexion dispositif 2 porte ici la référence 6.

Avantageusement, chacune des bornes de connexion 6 et 8 comporte au moins un plot de contact, par exemple pour faciliter le raccordement de ladite borne de connexion avec un élément électriquement conducteur extérieur, tel qu'un câble ou une barre de raccordement.

Dans l'exemple illustré, la borne 8 comporte deux plots de contact 81, 82 et la borne 6 comporte deux plots de contact 61 et 62.

Par exemple, la borne 4 comporte également un ou plusieurs tels plots de contact, ici au nombre de trois et portant les références 41, 42 et 43.

Le dispositif 2 comporte également un circuit électronique de commande 10 configuré pour piloter les premier et deuxième interrupteurs de puissance S1, S2, plus particulièrement pour piloter la commutation des transistors T1 et T2 en fonction d'un signal de commande.

Selon des exemples, pour piloter les interrupteurs S1 et S2, le circuit de commande 10 peut être connecté à des électrodes de commande des interrupteurs S1 et S2, notamment aux électrodes G1 et G2.

Par exemple, selon des modes de réalisation, le circuit de commande 10 comporte un microcontrôleur ou un microprocesseur programmé pour exécuter des instructions et/ou un code logiciel stockés en mémoire dans un support lisible par ordinateur, tel qu'une mémoire non volatile, afin de mettre en œuvre un ou plusieurs algorithmes, notamment un procédé de commande des interrupteurs S1 et S2.

En variante, selon d'autres modes de réalisation, le circuit de commande 10 comporte un circuit intégré dédié configuré pour mettre en œuvre ledit procédé.

Selon des exemples, le circuit électronique de commande 10 est monté sur une plaque de support 16.

En pratique, des composants formants ledit circuit électronique de commande 10 sont montés sur la plaque de support et sont par exemple connectés par des câbles ou des pistes électriquement conductrices formées sur ou dans la plaque de support 16.

Par exemple, la plaque de support 16 est une plaque de forme plane et de préférence rigide. Il peut s'agir d'une plaque de résine du type FR4 ou de tout autre matériau approprié.

Selon des modalités de mise en œuvre, le dispositif 2 comporte un boîtier 18.

Par exemple, le boîtier 18 est réalisé en un matériau isolant tel qu'un polymère, de préférence un polymère moulé, ou un matériau composite.

Les premier et deuxième interrupteurs S1 et S2 sont ici logés à l'intérieur du boîtier 18.

Les bornes de connexion 6 et 8, voire éventuellement la borne 4 et les électrodes G1 et G2, sont en revanche disposées de manière à être accessibles depuis l'extérieur du boîtier.

Notamment, le boîtier 18 inclut une face principale sur laquelle sont disposées les première et deuxième bornes de connexion 6 et 8.

Par exemple, la face principale est une face supérieure du boîtier 18.

Selon l'exemple illustré, le boîtier 18 présente une forme de pavé, par exemple avec une portion de base de forme rectangulaire.

Le circuit de commande 10 est en revanche disposé à l'extérieur du boîtier 18.

Par exemple, la plaque de support 16 sur laquelle est formé le circuit de commande 10 est montée sur boîtier 18, par exemple rapportée à l'extérieur du boîtier 18 tout en étant fixée à ce dernier.

Selon des modes de réalisation, le dispositif 2 est formé à partir d'un appareil électrique préformé, tel qu'un pack de puissance (« power pack » en anglais), notamment un module MOSFET, sur lequel est rajoutée la plaque de support 16.

Selon des exemples, les bornes de connexion 6, 8 sont disposées côte à côte et de préférence alignées dans un même plan géométrique P1, ici parallèle à la face principale du boîtier 18.

Dans l'exemple illustré, le plan P1 est perpendiculaire à une direction verticale du boîtier 18.

Par exemple, dans l'exemple illustré, les bornes de connexion 6, 8 présentent une forme rectangulaire et sont disposées parallèlement à un axe X12 passant par le plan P1, de part et d'autre de l'axe X12, cet axe X12 étant ici horizontal et parallèle à l'un des bords du boîtier 18.

De préférence, les plots de contact 61, 62 sont alignés parallèlement à l'axe X12, et il en va de même pour les plots de contact 81, 82.

Selon des modes de mise en œuvre, la plaque de support 16 comporte avantageusement un évidement de forme complémentaire à la forme de la portion du boîtier 18 sur laquelle sont montées les bornes de connexion 6 et 8.

Par exemple, l'évidement présente une forme essentiellement rectangulaire ou une forme de polyèdre. On comprend que, de façon générale, la forme de l'évitement est adaptée à la forme du boîtier 18.

Par exemple, sur la figure 2, la référence « e1 » désigne la distance séparant un bord de l'évidement de la portion du boîtier 18 sur laquelle sont montées les bornes de connexion 6 et 8.

Le dispositif 2 comporte également un appareil de détection pour détecter un défaut électrique tel qu'un court-circuit, survenant par exemple à l'intérieur du dispositif 2, par exemple dans ou entre les interrupteurs S1 et S2.

L'appareil de détection comporte au moins une bobine 12 associée aux bornes de connexion 6, 8 ainsi qu'un circuit électronique de traitement 14 configuré pour identifier la présence d'un défaut électrique dans le dispositif en fonction de la tension électrique mesurée par la bobine 12, cette tension électrique étant représentative du champ magnétique mesuré par la bobine 12.

Par exemple, la bobine 12 est agencée pour mesurer le champ magnétique créé dans le plan P1 par un ou des courants électriques qui circulent par les bornes 6 et/ou 8.

A cet effet, la bobine 12 est montée sur la plaque de support 16 parallèlement aux bornes de connexion 6, 8 pour mesurer le champ magnétique dans ledit plan P1.

Plus précisément, la bobine 12 est configurée pour générer une tension qui est fonction du champ magnétique créé dans ledit plan géométrique P1 par un ou des courants électriques qui circulent par les première et deuxième bornes de connexion 6, 8.

Selon des modes de réalisation, comme illustré sur la figure 2, l'appareil de détection comporte deux bobines 12.

Par exemple, une première bobine 12 est adjacente aux bornes de connexion 6 et 8. Une deuxième bobine 12, elle aussi adjacente aux bornes de connexion 6 et 8 est placée à l'opposé de la première bobine 12 par rapport aux bornes de connexion 6 et 8.

Dans l'exemple illustré, les bobines 12 sont alignées selon l'axe X12.

Par exemple, les bobines 12 sont placées de part et d'autre de l'entaille ou évidement, de préférence avec une disposition symétrique.

En variante, les bobines 12 peuvent être orientées différemment. En pratique, l'orientation de chaque bobine 12 est choisie en fonction de la configuration du dispositif de manière à améliorer la détection magnétique par les bobines 12.

En variante, l'appareil de détection peut ne comporter qu'une seule des deux bobines 12.

Selon des exemples, chaque bobine 12 comporte un ou plusieurs enroulements d'un conducteur électrique. Les bobines 12 peuvent être des bobines préformées, par exemple pré-enroulées sur un support préconstruit, qui sont ensuite montées ou soudées sur la plaque de support 16.

En variante, la ou les bobines 12 sont formées directement sur la plaque de support 16, par exemple par dépôt ou impression ou gravure d'un matériau électriquement conducteur dans ou sur la plaque de support 16.

Le circuit de traitement 14 est également formé sur la plaque de support 16.

Par exemple, selon des modes de réalisation, le circuit de traitement 14 comporte un microcontrôleur ou un microprocesseur programmé pour exécuter des instructions et/ou un code logiciel stockés en mémoire dans un support lisible par ordinateur, tel qu'une mémoire non volatile, afin de mettre en œuvre un ou plusieurs algorithmes, notamment un procédé de détection d'un défaut électrique.

En variante, selon d'autres modes de réalisation, le circuit de traitement 14 comporte un circuit intégré dédié ou un composant logique programmable configuré pour mettre en œuvre ledit procédé.

Dans certains modes de réalisation, au moins une partie des fonctions du circuit de traitement 14 peuvent être implémentées par le circuit de commande 10.

En d'autres termes, le circuit de traitement 14 et le circuit de commande 10 peuvent alors ne former qu'un seul et même circuit électronique ou ensemble de circuits électroniques.

Selon des exemples, le circuit de traitement 14 est programmé pour identifier la présence d'un défaut électrique notamment lors de la commutation d'un ou des deux interrupteurs S1 et S2, c'est-à-dire lorsqu'un des deux transistors T1 et T2 ou les deux transistors T1 et T2 est/sont commutés.

Plus précisément, le circuit de traitement 14 est par exemple configuré pour détecter un défaut électrique lors de la commutation des interrupteurs de puissance S1, S2 lorsque la tension générée par la bobine 12 est supérieure à un seuil de tension, ledit seuil de tension étant de préférence strictement supérieur à 0 Volts.

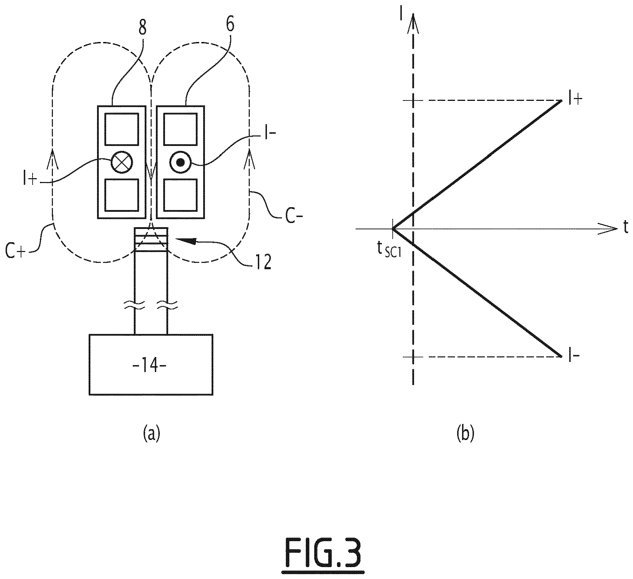

Les figures 3, 4 et 5 présentent différentes modalités d'identification d'un défaut électrique ou d'absence de défaut électrique selon certains scénarios prédéfinis, par exemple grâce à une programmation spécifique du circuit de traitement 14.

Ces modes de mise en œuvre ne sont toutefois donnés qu'à titre d'exemple illustratif et on comprend qu'en variante, le circuit de traitement 14 pourrait être programmé différemment pour identifier de tels défauts électriques.

Selon un premier exemple illustré par la figure 3, le circuit de traitement 14 est configuré pour détecter un défaut électrique lors de la commutation des interrupteurs de puissance S1, S2 lorsque le champ magnétique mesuré par l'appareil de détection indique que l'intensité du courant I₊ entrant par la première borne de connexion 8 augmente dans des mêmes proportions que l'intensité du courant I- sortant par la deuxième borne de connexion 6, les sens de circulation de ces deux courants étant opposés par rapport à la borne de connexion respective qu'ils traversent (l'un entre dans la borne 8, l'autre sort de la borne 6).

Un tel défaut correspond notamment à un court-circuit interne au boîtier 18, dans le sens où la première borne de connexion 8 est en court-circuit avec la deuxième borne de connexion 6, c'est-à-dire que les première et deuxième bornes sont reliées électriquement par un élément assimilable à un fil électrique conducteur, c'est-à-dire via les transistors T1 et T2 qui sont simultanément dans l'état passant.

Sur la figure 3, la sous-figure (a) représente schématiquement les bornes 6 et 8 du dispositif 2 selon une vue de dessus.

Sur ce schéma, la référence C+ désigne une ligne de champ magnétique dans le plan P1 correspondant au champ magnétique induit par la circulation du courant I₊ passant par la borne 8, par exemple entrant dans le dispositif 2.

La référence C- désigne une ligne de champ magnétique dans le plan P1 correspondant au champ magnétique induit par la circulation du courant I- passant par la borne 6, par exemple sortant du dispositif 2.

Ce premier exemple correspond à un défaut électrique de type court-circuit survenant lors de la commutation des interrupteurs S1 et S2, c'est-à-dire lorsque les transistors T1 et T2 sont dans leur état passant en même temps ou qu'un élément assimilable à un fil relie les bornes de connexion 6 et 8, alors qu'une tension continue est appliquée entre les bornes 6 et 8. Un courant électrique de court-circuit circule au travers des transistors T1 et T2 entre les bornes 6 et 8 alors que l'un des transistors T1 ou T2 devraient normalement être dans l'état bloquant.

Comme illustré par le graphique sur la sous-figure (b), un courant I₊ entrant circule au travers de la borne 8 et un courant I-, de même amplitude et de signe opposé, circule au travers de la borne 6. Leurs amplitudes, notées sur l'axe des ordonnées « I », augmentent en valeur absolue au cours du temps, noté « t », à partir de l'instant t_{SC1}.

La tension mesurée par la ou les bobines 12 augmente rapidement à l'instant t_{SC1} puis reste stable lorsque les amplitudes des courants I₊ et I- continuent à augmenter.

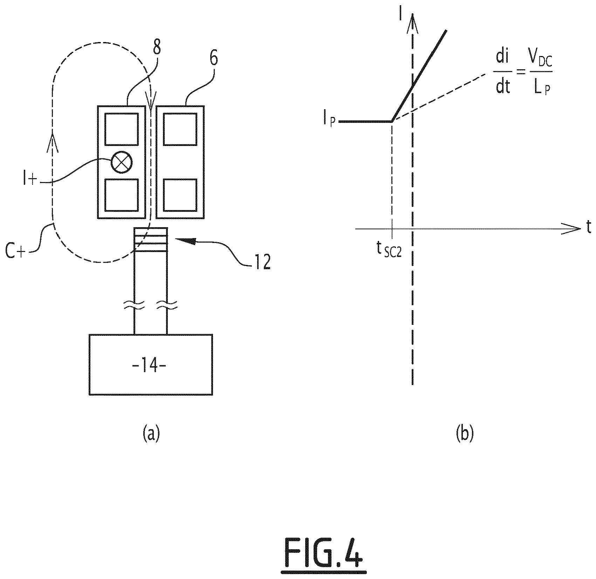

Selon un deuxième exemple illustré par la figure 4, le circuit de traitement 14 est configuré pour détecter un défaut électrique lors de la commutation des interrupteurs de puissance S1, S2 lorsque le champ magnétique mesuré par l'appareil de détection indique que l'intensité du courant I₊ entrant par la borne de connexion 8 augmente alors qu'aucun courant ne circule par la borne de connexion 6.

Un tel défaut correspond notamment à un court-circuit externe au boîtier 18, dans le sens où cela signifie notamment que le courant transitant par la borne de sortie augmente alors qu'il devrait être globalement stable. Un tel défaut intervient par exemple lorsque la borne de sortie est reliée à la terre alors que la première borne 8 est à un potentiel élevé.

Sur la figure 4, la sous-figure (a) représente schématiquement les bornes 6 et 8 du dispositif 2 selon une vue de dessus.

Sur ce schéma, la référence C+ désigne une ligne de champ magnétique dans le plan P1 correspondant au champ magnétique induit par la circulation du courant I₊ passant par la borne 8, par exemple entrant dans le dispositif 2.

Ce deuxième exemple correspond à un défaut électrique de type court-circuit survenant lorsqu'un courant électrique de court-circuit circule au travers du transistor T1 puis par la borne 4 sans passer par le transistor T2.

Comme illustré par le graphique sur la sous-figure (b), un courant I₊ entrant circule au travers de la borne 8 puis au travers du transistor T1 et un courant I_{P} de même amplitude sort par la borne 4. L'amplitude du courant I_{P}, sensiblement égale à celle du courant I₊, notée sur l'axe des ordonnées « I », augmente en valeur absolue au cours du temps, noté « t », à partir de l'instant t_{SC2}. La tension mesurée par la ou les bobines 12 augmente avec l'amplitude du courant I_{P}.

Par exemple, la dérivée temporelle di/dt du courant I_{P} est plus importante pendant la phase de commutation des interrupteurs qu'après la commutation.

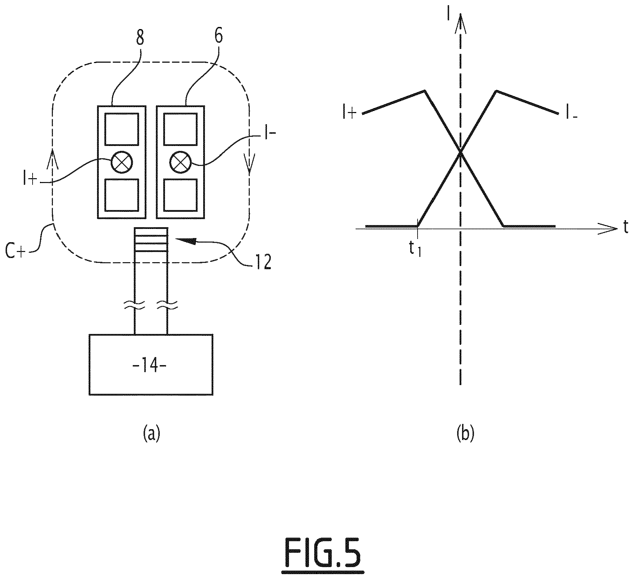

Selon un troisième exemple illustré par la figure 5, le circuit de traitement 14 est configuré pour considérer qu'aucun défaut électrique n'est présent lors de la commutation des interrupteurs de puissance S1, S2 lorsque le champ magnétique mesuré par l'appareil de détection indique que la variation de l'intensité du courant I₊ passant par la première borne de connexion 8 est opposée à la variation de l'intensité du courant I- passant par la deuxième borne de connexion 6, les sens de circulation de ces deux courants I₊ et I- étant les mêmes par rapport à la borne de connexion respective qu'ils traversent.

Sur la figure 5, la sous-figure (a) représente schématiquement les bornes 6 et 8 du dispositif 2 selon une vue de dessus.

Sur ce schéma, la référence C+ désigne une ligne de champ magnétique dans le plan P1 correspondant au champ magnétique induit par la circulation des courants I₊ et I- passant par les bornes 6 et 8, par exemple entrant tous les deux dans le dispositif 2.

Ce troisième exemple correspond à une situation normale en l'absence de défaut électrique dans lequel la borne de sortie est notamment connectée à une charge inductive, tel un moteur de traction ferroviaire : le transistor T1, initialement dans un état passant, est commuté vers un état bloquant alors que le transistor T2 est déjà dans un état bloquant.

Comme illustré par le graphique sur la sous-figure (b), initialement, un courant électrique entrant I₊ circule au travers du transistor T1 puis vers la borne 4 depuis le point milieu P. Suite à la commutation du transistor T1, survenant à un instant t₁, l'intensité du courant I₊ diminue jusqu'à devenir nulle. Un courant I- entrant par la borne 6, de même signe, circule au travers de la diode D2 et voit son amplitude augmenter puis se stabiliser (il s'agit du courant issu de la charge inductive). La tension mesurée par la ou les bobines 12 est presque nulle en raison de la configuration du champ magnétique induit par ces courants et, notamment, par le fait que l'augmentation du courant I₊ induit une augmentation de la tension entre les bornes de la bobine qui est compensée par une décroissance du courant I- qui induit une diminution de la tension entre les bornes de la bobine.

Un fonctionnement globalement similaire, serait observé avec :
- le transistor T2 commuté vers un état bloquant alors que le transistor T1 est déjà dans un état bloquant, ou
- le transistor T2 commuté vers un état bloquant alors que le transistor T1 est commuté vers un état passant, ou
- le transistor T1 commuté vers un état bloquant alors que le transistor T2 est commuté vers un état passant.

Ces différents exemples et modes de réalisation, et bien d'autres encore, peuvent également être combinés entre eux pour, par exemple, que le circuit de traitement 14 soit capable d'identifier des défauts électriques selon plusieurs des cas de figure décrits ci-dessus.

Un exemple de fonctionnement du dispositif 2 est maintenant décrit, par exemple en référence à la commutation du seul interrupteur S1, même si en pratique l'exemple est tout autant applicable à la commutation de l'interrupteur S2 et/ou à la commutation simultanée des deux interrupteurs S1 et S2.

Initialement, l'interrupteur S1 est dans un état électriquement ouvert.

Ensuite, le circuit de commande 10 déclenche la commutation du transistor T1 vers l'état fermé, par exemple en réponse à la réception d'un signal de commande.

Le circuit de traitement 14 mesure la tension aux bornes de la ou des bobines 12 et analyse automatiquement la ou les valeurs de tension mesurées par exemple pour identifier une défaillance ou pour identifier un fonctionnement normal. Il identifie notamment une défaillance lorsque la tension mesurée aux bornes de la ou des bobines est sensiblement non nulle.

Par exemple, cette identification est faite sur la base de l'évolution des valeurs de la tension mesurées et/ou d'un seuil particulier franchi par ces valeurs et/ou d'un motif particulier pris par l'évolution de ces valeurs au cours du temps.

Un défaut électrique est considéré comme étant identifié si les mesures sont révélatrices d'un comportement qui ne correspond pas à l'état dans lequel le ou les interrupteurs S1, S2 devraient se trouver à l'issue de la commutation.

Lorsqu'un défaut électrique est identifié par le circuit de traitement 14, ce dernier peut envoyer un signal d'alarme, par exemple à destination du circuit de commande 10 pour rouvrir le transistor T1, et/ou à destination d'un circuit de commande extérieur, par exemple pour interrompre l'alimentation électrique du dispositif 2.

Comme expliqué précédemment, le dispositif 2 peut être connecté à un ou à plusieurs autres dispositifs 2 pour former un circuit électrique.

Par exemple, un convertisseur de puissance comporte une pluralité de dispositifs 2, les interrupteurs de puissance desdits dispositifs étant raccordés de façon à former un circuit de conversion de puissance, tel qu'un convertisseur alternatif-continu (AC-DC) ou convertisseur continu-alternatif (DC-AC).

Selon un exemple, trois dispositifs 2 sont connectés ensemble en parallèle, chacun étant associé à une branche du convertisseur.

Par exemple, les bornes de raccordement 6 et 8 correspondent à des bornes pour appliquer une tension continue d'entrée, tandis que la borne 4 correspond à une phase d'une tension alternative de sortie.

Avantageusement, un tel convertisseur de puissance peut être utilisé dans un équipement électrique de traction ferroviaire, bien que d'autres utilisations soient possibles en variante.

Grâce à l'invention, la mesure du champ magnétique permet de détecter une variation du courant électrique et ainsi d'identifier rapidement un comportement révélateur d'un défaut électrique, notamment un court-circuit, de préférence lorsque la commutation des interrupteurs de puissance est amorcée, par exemple en moins de 2 microsecondes (us) ou en moins de 1us.

Un tel défaut électrique peut ainsi être identifié plus rapidement dans le dispositif qu'avec les méthodes classiquement utilisées, ce qui permet d'interrompre l'alimentation électrique avant que le dispositif ne soit endommagé.

De plus, en plaçant l'appareil de détection sur la plaque de support 16 par ailleurs déjà utilisée pour former le circuit de commande 10, l'intégration de l'appareil de détection est faite de façon particulièrement aisée et peu encombrante sans avoir besoin de modifier le reste du dispositif 2.

Cela permet aussi, lorsque plusieurs dispositifs 2 sont connectés ensemble pour former un circuit électrique, notamment un convertisseur de puissance, de pouvoir détecter un défaut au niveau d'un dispositif 2 et donc de localiser le défaut précisément dans le convertisseur plutôt que d'identifier un défaut uniquement à l'échelle d'un convertisseur entier.

Les modes de réalisation et les variantes envisagés ci-dessus peuvent être combinés entre eux pour générer de nouveaux modes de réalisation.

## Revendications

1. Dispositif (2), notamment un dispositif électronique de puissance, comportant :
- un premier interrupteur de puissance (S1) et un deuxième interrupteur de puissance (S2) connectés en série entre des première et deuxième bornes de connexion (8, 6) du dispositif ;
- un circuit électronique de commande (10) configuré pour piloter les premier et deuxième interrupteurs de puissance (S1, S2) ;
- un appareil de détection comportant au moins une bobine (12) associée aux première et deuxième bornes de connexion;
- un circuit électronique de traitement (14) configuré pour identifier la présence d'un défaut électrique dans le dispositif en fonction d'une tension électrique mesurée par la bobine (12), le circuit électronique de traitement (14) étant monté sur une plaque de support (16) et les première et deuxième bornes de connexion (8, 6) étant disposées côte à côte, et de préférence alignées, sensiblement dans un même plan géométrique (P1), la bobine étant montée sur la plaque de support (16) parallèlement aux première et deuxième bornes de connexion pour mesurer le champ magnétique dans ledit plan ; et- un boîtier (18) incluant une face principale sur laquelle sont disposées les première et deuxième bornes de connexion (8, 6), la plaque de support (16) étant fixée sur ladite face principale, les premier et deuxième interrupteurs (S1, S2) étant logés à l'intérieur du boîtier, et dans lequel la plaque de support (16) comporte un évidement de forme complémentaire à une portion du boîtier (18) sur laquelle sont montées les première et deuxième bornes de connexion (8, 6), le circuit de commande étant monté sur la plaque de support (16).

2. Dispositif selon la revendication 1, dans lequel la bobine (12) est adjacente aux première et deuxième bornes de connexion et est configurée pour générer une tension qui est fonction du champ magnétique créé dans ledit plan géométrique par un ou des courants électriques qui circulent par les première et deuxième bornes de connexion.

3. Dispositif selon la revendication 2, dans lequel le circuit de traitement (14) est configuré pour détecter un défaut électrique lors de la commutation des interrupteurs de puissance (S1, S2) lorsque la tension générée par la bobine est supérieure à un seuil de tension, ledit seuil de tension étant de préférence supérieur strictement à 0 Volts.

4. Dispositif selon l'une quelconque des revendications précédentes, lequel comporte une deuxième bobine (12) montée sur la plaque de support (16) et connectée au circuit de traitement (14), la deuxième bobine étant adjacente aux première et deuxième bornes de connexion et placée à l'opposé de l'autre bobine par rapport aux première et deuxième bornes de connexion.

5. Dispositif selon l'une quelconque des revendications précédentes, dans lequel le circuit de traitement (14) est configuré pour détecter un défaut électrique lors de la commutation des interrupteurs de puissance (S1, S2) lorsque le champ magnétique mesuré par l'appareil de détection indique que l'intensité du courant (I₊) entrant par la première borne de connexion (8) augmente dans des mêmes proportions que l'intensité du courant (I-) sortant par la deuxième borne de connexion (6), les sens de circulation de ces deux courants étant opposés.

6. Dispositif selon l'une quelconque des revendications précédentes, dans lequel le circuit de traitement (14) est configuré pour détecter un défaut électrique lors de la commutation des interrupteurs de puissance (S1, S2) lorsque le champ magnétique mesuré par l'appareil de détection indique que l'intensité du courant (I₊) entrant par la première borne de connexion (8) augmente alors qu'aucun courant ne circule par la deuxième borne de connexion (6).

7. Dispositif selon l'une quelconque des revendications précédentes, dans lequel le circuit de traitement (14) est configuré pour considérer qu'aucun défaut électrique n'est présent lors de la commutation des interrupteurs de puissance (S1, S2) lorsque le champ magnétique mesuré par l'appareil de détection indique que la variation de l'intensité du courant (I₊) passant par la première borne de connexion (8) est opposée à la variation de l'intensité du courant (I-) passant par la deuxième borne de connexion (6), les sens de circulation de ces deux courants étant les mêmes.

8. Convertisseur de puissance comportant une pluralité de dispositifs de commutation électrique (2) chacun conforme à l'une quelconque des revendications précédentes, les interrupteurs de puissance (S1, S2) desdits dispositifs étant raccordés de façon à former un circuit de conversion de puissance.

## Patentansprüche

1. Vorrichtung (2), insbesondere eine elektronische Leistungsvorrichtung, umfassend:
- einen ersten Leistungsschalter (S1) und einen zweiten Leistungsschalter (S2), die zwischen einem ersten und einem zweiten Verbindungsanschluss (8, 6) der Vorrichtung in Reihe verbunden sind;
- eine elektronische Steuerschaltung (10), die konfiguriert ist, um den ersten und den zweiten Leistungsschalter (S1, S2) anzusteuern;
- ein Erfassungsgerät, umfassend mindestens eine Spule (12), die mit dem ersten und dem zweiten Verbindungsanschluss assoziiert ist;
- eine elektronische Verarbeitungsschaltung (14), die konfiguriert ist, um das Vorhandensein eines elektrischen Fehlers in der Vorrichtung basierend auf einer von der Spule (12) gemessenen elektrischen Spannung zu identifizieren, wobei die elektronische Verarbeitungsschaltung (14) auf einer Trägerplatte (16) montiert ist und der erste und der zweite Verbindungsanschluss (8, 6) Seite an Seite und vorzugsweise fluchtend im Wesentlichen in derselben geometrischen Ebene (P1) angeordnet sind, wobei die Spule auf der Trägerplatte (16) parallel zu dem ersten und dem zweiten Verbindungsanschluss montiert ist, um das Magnetfeld in der Ebene zu messen; und ein Gehäuse (18), das eine Hauptfläche beinhaltet, auf der der erste und der zweite Verbindungsanschluss (8, 6) angeordnet sind, wobei die Trägerplatte (16) an der Hauptfläche befestigt ist, wobei sich der erste und der zweite Schalter (S1, S2) im Inneren des Gehäuses befinden, und wobei die Trägerplatte (16) eine Aussparung mit komplementärer Form zu einem Abschnitt des Gehäuses (18) umfasst, an dem der erste und der zweite Verbindungsanschluss (8, 6) montiert sind, wobei die Steuerschaltung an der Trägerplatte (16) montiert ist.

2. Vorrichtung nach Anspruch 1, wobei die Spule (12) an den ersten und den zweiten Verbindungsanschluss angrenzt und konfiguriert ist, um eine Spannung zu erzeugen, die von dem Magnetfeld abhängt, das in der geometrischen Ebene durch einen oder mehrere elektrische Ströme erzeugt wird, die durch den ersten und den zweiten Verbindungsanschluss fließen.

3. Vorrichtung nach Anspruch 2, wobei die Verarbeitungsschaltung (14) konfiguriert ist, um beim Schalten der Leistungsschalter (S1, S2) einen elektrischen Fehler zu erkennen, wenn die von der Spule erzeugte Spannung höher als ein Spannungsschwellenwert ist, wobei der Spannungsschwellenwert vorzugsweise strikt größer als 0 Volt ist.

4. Vorrichtung nach einem der vorherigen Ansprüche, die eine zweite Spule (12) umfasst, die auf der Trägerplatte (16) montiert und mit der Verarbeitungsschaltung (14) verbunden ist, wobei die zweite Spule an den ersten und den zweiten Verbindungsanschluss angrenzt und in Bezug auf den ersten und den zweiten Verbindungsanschluss gegenüber der anderen Spule platziert ist.

5. Vorrichtung nach einem der vorherigen Ansprüche, wobei die Verarbeitungsschaltung (14) konfiguriert ist, um beim Schalten der Leistungsschalter (S1, S2) einen elektrischen Fehler zu erkennen, wenn das von dem Erfassungsgerät gemessene Magnetfeld angibt, dass die Stromstärke (I+), die über den ersten Verbindungsanschluss (8) einfließt, in den gleichen Proportionen ansteigt wie die Stromstärke (I-), die über den zweiten Verbindungsanschluss (6) ausfließt, wobei die Fließrichtungen dieser zwei Ströme entgegengesetzt sind.

6. Vorrichtung nach einem der vorherigen Ansprüche, wobei die Verarbeitungsschaltung (14) konfiguriert ist, um beim Schalten der Leistungsschalter (S1, S2) einen elektrischen Fehler zu erkennen, wenn das von dem Erfassungsgerät gemessene Magnetfeld angibt, dass die Stromstärke (I+), die über den ersten Verbindungsanschluss (8) einfließt, ansteigt, während über den zweiten Verbindungsanschluss (6) kein Strom fließt.

7. Vorrichtung nach einem der vorherigen Ansprüche, wobei die Verarbeitungsschaltung (14) konfiguriert ist, um beim Schalten der Leistungsschalter (S1, S2) davon auszugehen, dass kein elektrischer Fehler vorhanden ist, wenn das von dem Erfassungsgerät gemessene Magnetfeld angibt, dass die Änderung der Stromstärke (I+), die durch den ersten Verbindungsanschluss (8) fließt, der Änderung der Stromstärke (I-), die durch den zweiten Verbindungsanschluss (6) fließt, entgegengesetzt ist, wobei die Fließrichtungen dieser zwei Ströme gleich sind.

8. Leistungswandler, umfassend eine Vielzahl von elektrischen Schaltvorrichtungen (2), die jeweils einem der vorherigen Ansprüche entsprechen, die Leistungsschalter (S1, S2) der Vorrichtungen verbunden sind, um eine Leistungsumwandlungsschaltung zu bilden.

## Claims

1. Device (2), in particular an electronic power device, including:
- a first power switch (S1) and a second power switch (S2) that are connected in series between first and second connection terminals (8, 6) of the device;
- an electronic control circuit (10) configured to control the first and second power switches (S1, S2);
a detection apparatus including at least one coil (12) associated with the first and second connection terminals;
an electronic processing circuit (14) configured to identify the presence of an electric fault in the device as a function of an electric voltage measured by the coil (12), the electronic processing circuit (14) being mounted on a support plate (16) and the first and second connection terminals (8, 6) being arranged side by side, and preferably aligned, substantially in a same geometric plane {P1), the coil being mounted on the support plate (16) parallel to the first and second connection terminals to measure the magnetic field in said plane; and
a case (18) including a main face on which the first and second connection terminals (8, 6) are arranged, the support plate (16) being attached on said main face, the first and second switches (S1, S2) being housed inside the case, and wherein the support plate (16) includes a recess with a shape complementary to a portion of the case (18) on which the first and second connection terminals (8, 6) are mounted, the control circuit being mounted on the support plate (16).

2. Device according to claim 1, wherein the coil (12) is adjacent to the first and second connection terminals and is configured to generate a voltage that is a function of the magnetic field created in said geometric plane by one or several electric currents that circulate through the first and second connection terminals.

3. Device according to claim 2, wherein the processing circuit (14) is configured to detect an electric fault during the switching of the power switches (S1, S2) when the voltage generated by the coil is above a voltage threshold, said voltage threshold preferably being strictly greater than 0 Volts.

4. Device according to any one of the preceding claims, wherein it includes a second coil (12) mounted on the support plate (16) and connected to the processing circuit (14), the second coil being adjacent to the first and second connection terminals and placed opposite the other coil relative to the first and second connection terminals.

5. Device according to any one of the preceding claims, wherein the processing circuit (14) is configured to detect an electric fault during the switching of the power switches (S1, S2) when the magnetic field measured by the detection apparatus indicates that the intensity of the current (I+) entering through the first connection terminal (8) is increasing in the same proportions as the intensity of the current (I-) exiting through the second connection terminal (6), the circulation direction of these two currents being opposite.

6. Device according to any one of the preceding claims, wherein the processing circuit (14) is configured to detect an electric fault during the switching of the power switches (S1, S2) when the magnetic field measured by the detection apparatus indicates that the intensity of the current (I+) entering through the first connection terminal (8) is increasing when no current is circulating through the second connection terminal (6).

7. Device according to any one of the preceding claims, wherein the processing circuit (14) is configured to consider that no electric fault is present during the switching of the power switches (S1, S2) when the magnetic field measured by the detection apparatus indicates that the variation of the intensity of the current (I+) passing through the first connection terminal (8) is opposite the variation of the intensity of the current (I-) exiting through the second connection terminal (6), the circulation directions of these two currents being the same.

8. A power converter including a plurality of electric switching devices (2) each according to any one of the preceding claims, the power switches (S1, S2) of said devices being connected so as to form a power conversion circuit.
